(19) Europäisches Patentamt
European Patent Office
Office européen des brevets

(11) **EP 3 128 674 B1**

(12) **EUROPÄISCHE PATENTSCHRIFT**

(45) Veröffentlichungstag und Bekanntmachung des Hinweises auf die Patenterteilung:
**25.08.2021 Patentblatt 2021/34**

(51) Int Cl.:
***H03M 1/46*** *(2006.01)*

(21) Anmeldenummer: **16180800.1**

(22) Anmeldetag: **22.07.2016**

(54) **SUKZESSIV-APPROXIMATIONS-VERFAHREN MIT NICHTLINEARER CHARAKTERISTIK**

SUCCESSIVE APPROXIMATION METHOD WITH NON-LINEAR CHARACTERISTICS

PROCÉDÉ D'APPROXIMATIONS SUCCESSIVES AYANT UNE CARACTERISTIQUE NON LINEAIRE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **05.08.2015 DE 102015112852**

(43) Veröffentlichungstag der Anmeldung:
**08.02.2017 Patentblatt 2017/06**

(73) Patentinhaber: **Lantiq Beteiligungs-GmbH & Co. KG**
**85579 Neubiberg (DE)**

(72) Erfinder:
• **LOPEZ-DIAZ, Daniel**
**9500 Villach (AT)**
• **NIEDERFRINIGER, Thomas**
**9500 Villach (AT)**
• **KAHL, Alexander**
**9523 Landskron (AT)**
• **TRAUTMANN, Steffen**
**9500 Villach (AT)**

(74) Vertreter: **2SPL Patentanwälte PartG mbB**
**Landaubogen 3**
**81373 München (DE)**

(56) Entgegenhaltungen:
**JP-A- S5 544 256    JP-A- S5 797 222**
**US-A- 5 920 274**

• YUEN C K: "FLEXIBLE A/D CONVERSION USING A ROM IN PLACE OF A SAR", PROCEEDINGS OF THE IEEE, IEEE. NEW YORK, US, Bd. 71, Nr. 12, Dezember 1983 (1983-12), Seiten 1454-1456, XP007902652, ISSN: 0018-9219
• DINESH K ANVEKAR ET AL: "A PROGRAMMABLE NONLINEAR ADC USING OPTIMAL-SIZED ROM", IEEE TRANSACTIONS ON INSTRUMENTATION AND MEASUREMENT, IEEE SERVICE CENTER, PISCATAWAY, NJ, US, Bd. 40, Nr. 6, Dezember 1991 (1991-12), Seiten 1031-1035, XP000299427, ISSN: 0018-9456, DOI: 10.1109/19.119787
• SMITH B D: "Coding by Feedback Methods", PROCEEDINGS OF THE IRE, IEEE, PISCATAWAY, NJ, US, Bd. 39, Nr. 8, August 1953 (1953-08), Seiten 1053-1058, XP011153958, ISSN: 0096-8390
• XUAN ZHANG ET AL: "A 46- $\mu\hbox{W}$ Self-Calibrated Gigahertz VCO for Low-Power Radios", IEEE TRANSACTIONS ON CIRCUITS AND SYSTEMS II: EXPRESS BRIEFS, IEEE, US, vol. 58, no. 12, 1 December 2011 (2011-12-01), pages 847-851, XP011388895, ISSN: 1549-7747, DOI: 10.1109/TCSII.2011.2172530

**EP 3 128 674 B1**

**Beschreibung**

TECHNISCHES GEBIET

Verschiedene Ausführungsformen der Erfindung betreffen eine Schaltung, die einen sukzessiv-approximativen Analog-Digital-Wandler umfasst, und einen hybriden Analog-Digital-Wandler. Insbesondere betreffen verschiedene Ausführungsformen Techniken, um ein analoges Eingangssignal mit einer nichtlinearen Charakteristik in ein digitales Ausgangssignal zu wandeln.

HINTERGRUND

In verschiedenen Anwendungen kann es erstrebenswert sein, die Leistung eines analogen Wechselspannung-Signals (AC-Signal) als Eingangssignal über einen großen Dynamikbereich als Digitalwert zu bestimmen. Dazu sind verschiedene Techniken bekannt, wie zum Beispiel die Spitzenwert-Detektion oder ein Begrenzungsverstärker. Solche Techniken weisen jedoch den Nachteil auf, dass sie nicht einen Effektivwert, wie beispielsweise den quadratischen Mittelwert (englisch root mean square, RMS), bestimmen. Deshalb können solche Techniken insbesondere eine Abhängigkeit von einer Modulationstechnik des AC-Signals und/oder eine Abhängigkeit von einem Verhältnis zwischen Spitzenleistung-zu-Mittelwert, z.B. durch den Scheitelfaktor beschrieben, aufweisen.

Um den RMS-Wert zu bestimmen, sind Techniken bekannt, welche das AC-Signal zunächst quadrieren und dann mittels eines logarithmischen Analog-Verstärkers im Analogbereich übersetzen. Anschließend findet eine Analog-Digital(AD)-Wandlung mittels eines Analog-Digital-Wandlers (engl. Analog-to-Digital Converter; ADC) statt, um ein digitales Ausgangssignal zu erhalten. Hierzu kann zum Beispiel ein ADC eingesetzt werden, der gemäß des Wägeverfahrens betrieben wird; ein solcher ADC wird häufig auch als sukzessiv approximativer ADC (SAR-ADC) bezeichnet. Siehe hierzu Tietze, Schenk, Gamm, Halbleiterschaltungstechnik", 14. Auflage (2012), Kapitel 17.2.2 "Wägeverfahren mit geschalteten Spannungen".

Solche Techniken zum Bestimmen des RMS-Werts weisen jedoch den Nachteil auf, dass aufgrund der logarithmischen Verstärkung im Analogbereich mittels des Analog-Verstärkers eine signifikante Abhängigkeit von Randbedingungen, wie beispielsweise Prozesstoleranzen, Temperatur und der Versorgungsspannung vorliegen kann. Das Ausgangssignal kann dann entsprechend verfälscht sein. Eine Genauigkeit der AD-Wandlung kann abnehmen.

Ein Analog-Digital-Wandler nach dem Stand der Technik ist beispielsweise aus der Druckschrift US 5 920 274 A oder JPS5544256 bekannt.

ZUSAMMENFASSUNG

Deshalb besteht ein Bedarf für verbesserte Techniken der AD-Wandlung. Insbesondere besteht ein Bedarf für Techniken, die es ermöglichen, ein Eingangssignal, das eine Leistungskurve mit einem großen Dynamikbereich aufweist, zuverlässig und genau zu wandeln.

Diese Aufgabe wird von den Merkmalen der unabhängigen Ansprüche gelöst. Die abhängigen Ansprüche definieren Ausführungsformen.

Gemäß einer Ausführungsform betrifft die vorliegende Erfindung eine Schaltung. Die Schaltung umfasst einen SAR-ADC. Der SAR-ADC umfasst einen Rückkopplungszweig. Der Rückkopplungszweig ist eingerichtet, um ein Digitalsignal gemäß einer vorgegebenen Funktion zu übersetzen und um weiterhin das übersetzte Digitalsignal in ein analoges Rückkopplungssignal zu wandeln.

Gemäß einer Ausführungsform betrifft die vorliegende Erfindung ein Verfahren. Das Verfahren umfasst das Übersetzen eines Digitalsignals gemäß einer vorgegebenen Funktion mittels eines Rückkopplungszweigs eines SAR-ADC. Das Verfahren umfasst weiterhin das Wandeln des übersetzten Digitalsignals in ein analoges Rückkopplungssignals mittels des Rückkopplungszweigs des SAR-ADC.

Gemäß einer Ausführungsform betrifft die Erfindung einen hybriden ADC. Der hybride ADC umfasst einen Komparator, der eingerichtet ist, um ein analoges Eingangssignal mit einem Rückkopplungssignal zu vergleichen und um basierend auf dem vergleichen ein Ergebnissignal bereit zu stellen. Das Eingangssignal weist eine Leistungskurve mit einem ersten Bereich und einem zweiten Bereich auf. Der erste Bereich entspricht kleineren Leistungen als der zweite Bereich. Der hybride ADC umfasst weiterhin ein SAR-Register, das eingerichtet ist, um ein Digitalsignal iterativ basierend auf dem Ergebnissignal anzupassen. Der hybride ADC ist eingerichtet, um mittels einer nichtlinearen Charakteristik den ersten Bereich des Eingangssignals mit einer erkennbaren Sensitivität zu wandeln.

KURZBESCHREIBUNG DER FIGUREN

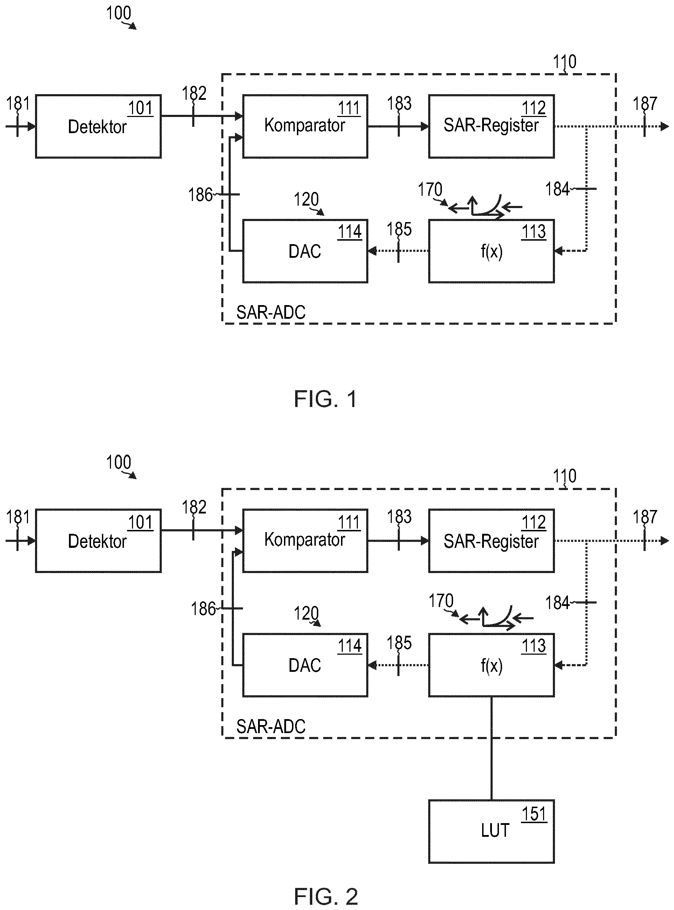

FIG. 1 illustriert eine Schaltung gemäß verschiedener Ausführungsformen, die nicht durch die angehängten Ansprüche gedeckt sind, wobei die Schaltung einen SAR-ADC umfasst, der einen Rückkopplungszweig aufweist, wobei ein Logikelement in dem Rückkopplungszweig angeordnet ist, welches eingerichtet ist, um ein Digitalsignal gemäß einer vorgegebenen Funktion zu übersetzen.

FIG. 2 entspricht FIG. 1, und illustriert eine Schaltung gemäß einer Ausführungsform die nicht durch die angehängten Ansprüche gedeckt ist, wobei das Logikelement eingerichtet ist, um das Digitalsignal gemäß der vorgegebenen Funktion basierend auf einer Nachschlagetabelle, die in einem Speicher gespeichert ist, zu übersetzen.

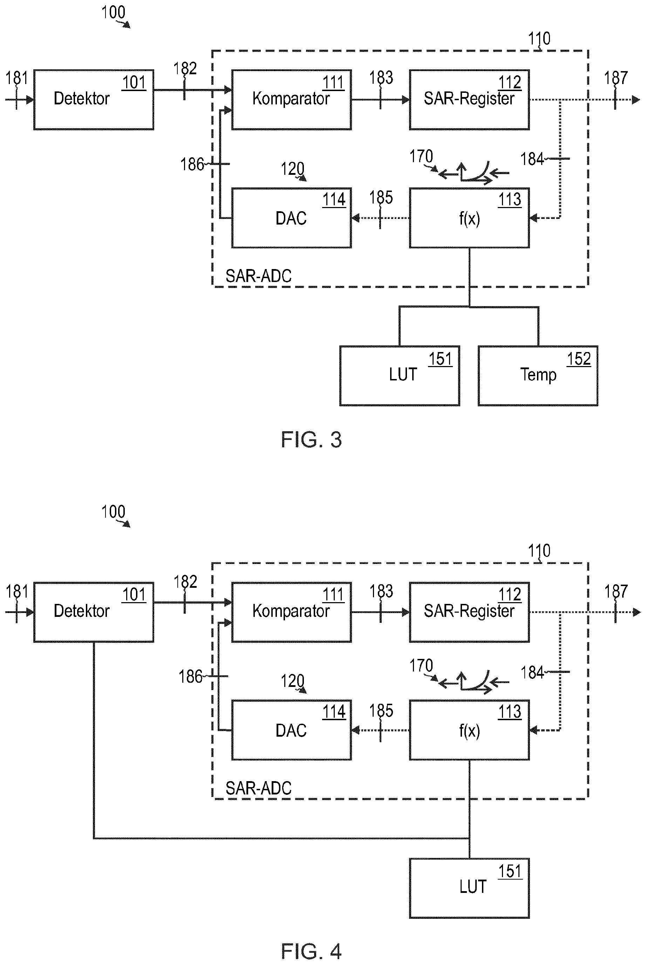

FIG. 3 entspricht FIG. 2, und illustriert eine Schaltung gemäß der Ausführungsform nach den angehängten Ansprüchen, wobei die Schaltung weiterhin einen Temperatursensor aufweist, wobei die vorgegebene Funktion eine Abhängigkeit von der Temperatur aufweist.

FIG. 4 entspricht FIG. 2, und illustriert eine Schaltung gemäß einer Ausführungsform die nicht durch die angehängten Ansprüche gedeckt ist, wobei die vorgegebene Funktion eine Abhängigkeit von einem Betriebszustand eines Detektors aufweist, der an den SAR-ADC ein analoges Eingangssignal ausgibt.

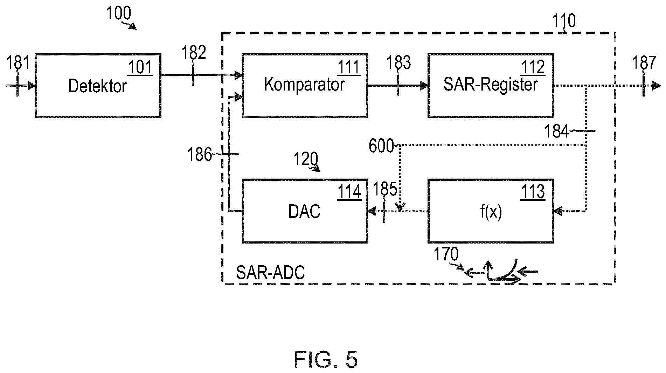

FIG. 5 entspricht FIG. 1, und illustriert eine Schaltung gemäß einer Ausführungsform die nicht durch die angehängten Ansprüche gedeckt ist, wobei der Rückkopplungszweig des SAR-ADC weiterhin einen selektiv aktivierbaren Nebenweg umfasst, der eingerichtet ist, um das digitale Logikelement zu umgehen.

FIG. 5 illustriert nichtlineare exponentielle vorgegebene Funktionen gemäß verschiedener Ausführungsformen, wobei die Funktionen durch eine Steigung und einen Nullpunktversatz charakterisiert sind.

FIG. 7 illustriert eine Leistungskurve des Eingangssignals, wobei die Leistungskurve einen großen Dynamikbereich aufweist.

FIG. 8 illustriert die nichtlineare Charakteristik des SAR-ADC.

FIG. 9 illustriert einen Bereich eine Sensitivität der nichtlinearen Charakteristik des SAR-ADC.

FIG. 10 ist ein Flussdiagramm eines Verfahrens gemäß verschiedener Ausführungsformen.

FIG. 11 illustriert einen SAR-ADC gemäß einer vorbekannten Referenzimplementierung.

DETAILLIERTE BESCHREIBUNG VON AUSFÜHRUNGSFORMEN

Nachfolgend wird die vorliegende Erfindung anhand bevorzugter Ausführungsformen unter Bezugnahme auf die Zeichnungen näher erläutert. In den Figuren bezeichnen gleiche Bezugszeichen gleiche oder ähnliche Elemente. Die Figuren sind schematische Repräsentationen verschiedener Ausführungsformen der Erfindung. In den Figuren dargestellte Elemente sind nicht notwendigerweise maßstabsgetreu dargestellt. Vielmehr sind die verschiedenen in den Figuren dargestellten Elemente derart wiedergegeben, dass ihre Funktion und genereller Zweck dem Fachmann verständlich wird. In den Figuren dargestellte Verbindungen und Kopplungen zwischen funktionellen Einheiten und Elementen können auch als indirekte Verbindung oder Kopplung implementiert werden. Eine Verbindung oder Kopplung kann drahtgebunden oder drahtlos implementiert sein.

Funktionale Einheiten können als Hardware, Software oder eine Kombination aus Hardware und Software implementiert werden.

Nachfolgend werden Techniken beschrieben, die eine AD-Wandlung eines analogen Eingangssignals betreffen; derart wird ein digitales Ausgangssignal erhalten. Insbesondere basiert die AD-Wandlung auf einem SAR-ADC bzw. dem Wägeverfahren. Dabei werden Techniken eingesetzt, welche es ermöglichen, eine besonders genaue und zuverlässige AD-Wandlung für das Eingangssignal durchzuführen, welches einen großen Dynamikbereich aufweist. Der Dynamikbereich kann sich auf eine bestimmte Kenngröße des Eingangssignals beziehen, wie zum Beispiel die Leistung. Dabei kann der SAR-ADC gemäß verschiedener Ausführungsformen eingerichtet sein, um mittels einer nichtlinearen Charakteristik einen ersten Bereich der Leistungskurve des Eingangssignals mit einer großen Sensitivität zu wandeln und einen zweiten Bereich der Leistungskurve des Eingangssignals mit einer geringen Sensitivität zu wandeln. Derart kann erreicht werden, dass über den großen Dynamikbereich der Leistungskurve des Eingangssignals das Ausgangssignal mit einer ausreichenden bzw. insbesondere erkennbaren Sensitivität bereitgestellt werden kann.

In verschiedenen Ausführungsformen kann die nichtlineare Charakteristik der AD-Wandlung geeignet sein, um einen RMS-Wert der Leistung des Eingangssignals bereitzustellen. Insofern kann insbesondere eine logarithmische Skala, wie beispielsweise eine dB Skala, in eine lineare Skala übersetzt werden. Solche Techniken können insbesondere in Bezug auf Eingangsstufen bei drahtloser Übertragung eines Funkkanals Anwendung finden. Eine spezifische Anwendung wäre Wireless Local Area Network (WLAN) Übertragung gem. der (Institute of Electrical and Electronics Engineers) IEEE 802.11 Standardfamilie. Ein weiterer Anwendungsbereich wäre drahtlose Übertragung mittels Funkzellen-Technologie, beispielsweise wie durch das Third Generation Partnership Project (3GPP) spezifiziert. Ein weiterer Anwendungsbereich wäre drahtlose Übertragung im Zusammenhang mit Internet der Dinge (engl. Internet of Things, IOT) Technologie. Bei solchen Anwendungen variiert nämlich typischerweise die Leistung des Eingangssignals in einem großen Dynamikbereich, beispielsweise im Bereich von 80 - 90 dB. Solche Techniken können auch im Bereich des "Connected Home" eingesetzt werden, z.B. im Zusammenhang mit einem WLAN Zugangspunkt (engl. WLAN Access Point of a Gateway).

In FIG. 1 ist eine Schaltung 100 gezeigt, die einen SAR-ADC 110 umfasst. Zum Beispiel kann die Schaltung 100 auf einem einzigen Halbleiterchip oder gebondetem Chip angeordnet sein. Der SAR-ADC 110 empfängt ein analoges Eingangssignal 182 und gibt ein digitales Ausgangssignal 187 aus. Das digitale Ausgangssignal 187 kann zum Beispiel indikativ für eine Amplitude des analogen Eingangssignals 182 sein. Das digitale Ausgangssignal 187 kann z.B. indikativ für einen RMS-Wert des Eingangssignals 182 sein.

Der SAR-ADC 110 empfängt das Eingangssignal 182 von einem Detektor 101. Der Detektor 101 kann eingerichtet sein, um das Eingangssignal 182 zum Beispiel basierend auf einer physikalischen Messgröße 181 bereitzustellen.

Es wäre in verschiedenen Ausführungsformen auch möglich, dass der Detektor 101 zum Beispiel ein Multiplikator oder ein Quadrier-Element ist, welches ein analoges Signal 181 abändert, um das Eingangssignal 182 zu erhalten. In verschiedenen Ausführungsformen kann der Detektor 101 auch eine Abtast-Halte-Schaltung (engl. sample-and-hold) implementieren. Es wäre zum Beispiel möglich, dass der Detektor 101 in diesem Zusammenhang einen Kondensator aufweist, der einen Tiefpassfilter implementiert. Es wäre alternativ oder zusätzlich in verschiedenen Ausführungsformen auch möglich, dass der Detektor 101 einen Integrator implementiert. Derart kann zum Beispiel erreicht werden, dass das Signal 181 über bestimmte Zeitbereiche integriert wird und basierend auf dem Integral das Eingangssignal 182 erzeugt wird und dem SAR-ADC 110 bereitgestellt wird. Es wäre alternativ oder zusätzlich in verschiedenen Ausführungsformen auch möglich, dass der Detektor 101 eine analoge Verstärker-Schaltung implementiert. Zum Beispiel wäre es möglich, dass der Detektor 101, je nach Betriebszustand, unterschiedliche Verstärkungsfaktoren der Verstärker-Schaltung anwendet. Beispiele für einen Betriebszustand umfassen z.B. eine Charakteristik des Detektors 101, einen selektierter Dynamikbereich des Detektors 101 und einen Verstärkungsfaktor des Detektors 101.

Im Allgemeinen kann die Schaltung 100 eingerichtet sein, um verschiedenste Eingangssignale 181 zu wandeln. Insbesondere kann das Eingangssignal 181 zum Beispiel ein Wechselfeld (engl. Alternating Current, AC) Hochfrequenz-Signal im Megahertz- oder Gigahertzbereich sein. Es wäre zum Beispiel möglich, dass das Eingangssignal 181 ein moduliertes Hochfrequenz-Signal ist.

Für die AD-Wandlung verwendet der SAR-ADC 110 Techniken des Wägeverfahrens. Insbesondere umfasst der SAR-ADC 110 einen Komparator 111, ein SAR-Register 112 und einen Rückkopplungszweig 120, wie aus Referenzimplementierungen des SAR-ADC 110 bekannt. Der Komparator 111 ist eingerichtet, um das analoge Eingangssignal 182 mit einem von dem Rückkopplungszweig 120 bereitgestellten analogem Rückkopplungssignal 186 zu vergleichen und, basierend auf diesem Vergleich, ein Ergebnissignal 183 an das SAR-Register 112 bereitzustellen. Zum Beispiel könnte der Komparator 111 eingerichtet sein, um eine logische EINS auszugeben, sofern das analoge Eingangssignal 182 eine Amplitude aufweist, die größer als eine Amplitude des Rückkopplungssignals 186 ist. Entsprechend könnte der Komparator 111 eingerichtet sein, um eine logische NULL auszugeben, sofern das analoge Eingangssignal 182 eine Amplitude aufweist, die kleiner als die Amplitude des Rückkopplungssignals 186 ist.

Das SAR-Register 112 ist eingerichtet, um ein Digitalsignal 184 auszugeben und des Digitalsignal 184 iterativ basierend auf dem von dem Komparator 111 bereitgestellten Ergebnissignal 183 anzupassen. Wenn die iterative Anpassung abgeschlossen ist, d.h. die AD-Wandlung abgeschlossen ist, entspricht das Digitalsignal 184 dem Ausgangssignal 187.

Das SAR-Register 112 kann eingerichtet sein, um einen Wert des Digitalsignals 184 während des Prozesses der AD-Wandlung zu speichern. Zum Beispiel kann das Digitalsignal 184 bzw. das Ausgangssignal 187 eine Bit-Abfolge von vorgegebener Länge aufweisen, zum Beispiel 8 Bit. Zum Beispiel kann ein initialer Wert des Digitalsignals 184 zu Beginn des Prozesses der AD-Wandlung auf NULL gesetzt werden. Anschließend kann das höchste Bit (engl. Most Significant Bit, MSB) auf EINS gesetzt werden und durch den Komparator mittels Vergleichen geprüft werden, ob die Amplitude des Eingangssignals 182 größer als die Amplitude des derart angepassten Digitalsignals 184 bzw. größer als die Amplitude des Rückkopplungssignals 186 ist, welches der analogen Repräsentation des angepassten Digitalsignals 184 entspricht.

Je nach Ergebnis des Vergleichens wird das MSB angepasst oder verbleibt auf EINS gesetzt. Anschließend kann das nächste Bit, MSB-1 auf EINS gesetzt werden; je nach Ergebnis des Vergleichens durch den Komparator 111 wird das MSB -1 wiederum auf NULL angepasst oder verbleibt auf EINS gesetzt.

Dieser Vorgang des iterativen Anpassens kann anschließend für alle weiteren Bit-Positionen des Digitalsignals 184 durchgeführt werden, bis letztendlich das niedrigste Bit (engl. Lowest Significant Bit, LSB) feststeht. Anschließend kann das Ausgangssignal 187 bereitgestellt werden.

Die voranstehend in Grundzügen beschriebene AD-Wandlung auf Grundlage des Wägeverfahrens ist dem Fachmann bekannt, sodass hier keine weiteren Details erläutert werden müssen. Herkömmliche SAR-ADC, die basierend auf dem Wägeverfahren operieren, weisen eine lineare Charakteristik der AD-Wandlung des Eingangssignals in das Ausgangssignal auf. Insbesondere findet kein Übersetzen des Digitalsignals 184 statt.

Der SAR-ADC 110 kann also eingerichtet sein, um das analoge Eingangssignal 182 gemäß der nichtlinearen Charakteristik zu wandeln. Nachfolgend werden Details in Bezug auf den Rückkopplungszweig 120 beschrieben. Insbesondere der Rückkopplungszweig 120 ist eingerichtet, um die nichtlineare Charakteristik des SAR-ADC 110 zu bewirken. Insbesondere ist der Rückkopplungszweig 120 eingerichtet, um das Digitalsignal 184 gemäß einer vorgegebenen Funktion 170 zu übersetzen und um weiterhin das übersetzte Digitalsignal 184 in das analoge Rückkopplungssignal 186 zu wandeln. Das analoge Rückkopplungssignal 186 wird anschließend an den Komparator 111 übergeben.

Im Detail umfasst der Rückkopplungszweig 120 ein digitales Logikelement 113 und ein Digital-Analog(DA)-Wandlerelement 114. Das digitale Logikelement 113 operiert im Digitalbereich. Das digitale Logikelement 113 ist eingerichtet, um das Digitalsignal 184 gemäß der vorgegebenen Funktion 170 zu übersetzen. Das DA-Wandlerelement 114 ist eingerichtet, um das übersetzte Digitalsignal 185 in das analoge Rückkopplungssignal 186 zu wandeln und um das analoge Rückkopplungssignal 186 an den Komparator 111 zu übergeben.

Das Übersetzen des Digitalsignals 184 bewirkt die nichtlineare Charakteristik des SAR-ADC 110. Je nach Ausgestaltung der vorgegeben Funktion 170 kann die nichtlineare Charakteristik abgewandelt werden. Da Logik in Form des Komparators 111 und des Logikelements 113 und des SAR-Register 112 sowohl im Analogbereich, als auch im Digitalbereich angeordnet ist, kann der SAR-ADC 110 auch als hybrider Analog-Digital-Wandler bezeichnet werden.

Die nichtlineare Charakteristik des SAR-ADC 110 kann erreicht werden, obgleich das DA-Wandlerelement 114 beispielsweise als lineares DA-Wandlerelement 114 ausgestaltet sein kann, also selbst eine lineare Charakteristik der DA-Wandlung aufweist.

Durch das Übersetzen des Digitalsignals 184 im Digitalbereich kann ein besonders stabiler und zuverlässiger Betrieb des SAR-ADC 110 erreicht werden. Insbesondere kann das Übersetzen des Digitalsignals 184 im Digitalbereich keine oder keine signifikante Abhängigkeit von der Temperatur oder anderen externen Einflüssen aufweisen, wie zum Beispiel Offset-Spannungen oder Prozessparametern. Derart kann erreicht werden, dass der SAR-ADC 110 die nichtlineare Charakteristik zuverlässig und stabil implementiert. Darüber hinaus kann die benötigte analoge Schaltungstechnik reduziert werden. Z.B. kann ein logarithmischer Analog-Verstärker entbehrlich sein.

In einem speziellen Szenario entspricht die vorgegebene Funktion 170 einer exponentiellen Funktion. In einem solchen Fall bewirkt die exponentielle vorgegebene Funktion 170, dass das Eingangssignal 182 mit einer logarithmischen nichtlinearen Charakteristik in das Ausgangssignal 187 gewandelt wird. Dies kann dazu verwendet werden, um das Ausgangssignal 187 indikativ für das Eingangssignal 182 in einer linear-in-dB Skala bereitzustellen. Dies kann insbesondere im Zusammenhang mit der Bestimmung des RMS-Werts des Signals 181 erstrebenswert sein.

Zum Beispiel kann das Bestimmen des RMS-Werts einen 2-stufigen Prozess umfassen. Zunächst kann das Signal 181 mittels des Detektors 101 quadriert werden, d.h. mit sich selbst multipliziert werden. Man erhält:

$$y = x^a,$$

wobei x das Signal 181 und y das Eingangssignal 182 bezeichnet. a ist ein Parameter der z.B. a = 2 betragen kann. *a* kann auch andere Werte annehmen, z.B. im Bereich 1,5 < a < 2,5.

Dann wird mittels der logarithmischen nichtlinearen Charakteristik der Logarithmus des Eingangssignals 182 bestimmt; dabei erfolgt das Bestimmen des Logarithmus im Digitalbereich mittels des SAR-ADC 110. Insbesondere wird der Logarithmus als nichtlineare Charakteristik der AD-Wandung durch das Übersetzen des Digitalsignals 184 mittels der exponentiellen vorgegebenen Funktion 170 mittels des Logikelements 113 im Digitalbereich erreicht. Dann wird das Ausgangssignal 187 erhalten, dass eine Bit-Abfolge aufweist, deren Wert linear in Bezug auf den RMS-Wert des Eingangssignals 182 variiert.

Durch die Implementierung des Logikelements 113 im Digitalbereich sind verschiedenste Varianten des Logikelements 113 denkbar. In verschiedenen Szenarien wäre es zum Beispiel möglich, dass das Logikelement 113 einen Prozessor umfasst, der eingerichtet ist, um das übersetzte Digitalsignal 185 basierend auf der vorgegebenen Funktion 170 und basierend dem Digitalsignal 184 zu berechnen. Zum Beispiel kann der Prozessor mit einem Speicher gekoppelt sein, in dem die vorgegebene Funktion hinterlegt ist (in FIG. 1 nicht gezeigt). Derart wäre es möglich, die vorgegebene Funktion flexibel anzupassen.

In Bezug auf FIG. 2 ist ein weiteres Szenario in Bezug auf die Implementierung des Logikelements 113 dargestellt. In dem Szenario der FIG. 2 umfasst die Schaltung 100 einen Speicher 151, der mit dem Logikelement 113 gekoppelt ist. Der Speicher 151 ist eingerichtet, um eine Nachschlagetabelle (engl. look up table, LUT) zu speichern. Die LUT bildet die vorgegebene Funktion 170 ab. Das Logikelement 113 ist eingerichtet, um das Digitalsignal 184 gemäß der vorgegebenen Funktion 170 basierend auf der LUT zu übersetzen.

Zum Beispiel könnte die LUT für verschiedene Digitalsignale 184 jeweils ein zugeordnetes übersetztes Digitalsignal 185 beinhalten. Dies bedeutet, dass eine bestimmte Bit-Abfolge des Digitalsignals 184, basierend auf der Zuordnung der LUT, in eine andere Bit-Abfolge des übersetzten Digitalsignals 185 übersetzt werden kann. Die Menge der in der LUT hinterlegten Zuordnungen kann dann die vorgegebene Funktion 170 abbilden. Durch das Verwenden der LUT kann es möglich sein, das Übersetzen im Logikelement 113 vergleichsweise einfach zu implementieren. Insbesondere kann es entbehrlich sein, bestimmte Rechenoperationen durchzuführen und es kann entbehrlich sein, einen entsprechenden Prozessor mit vergleichsweise großer Rechenleistung bereitzustellen.

In verschiedenen Szenarien ist es möglich, dass die LUT mehr als eine vorgegebene Funktion 170 abbildet. Zum Beispiel wäre es möglich, dass der Rückkopplungszweig 120 eingerichtet ist, um das Digitalsignal 184 in einem ersten Betriebsmodus gemäß der vorgegebenen Funktion 170 zu übersetzen und in einem zweiten Betriebsmodus gemäß einer anderen, weiteren vorgegebenen Funktion zu übersetzen. Derart wäre es möglich, dass die nichtlineare Charakteristik des SAR-ADC 110, mit welcher das Eingangssignal 182 in das Ausgangssignal 187 übersetzt wird, je nach Betriebsmodus verändert wird. Derart kann eine Flexibilität in Bezug auf die AD-Wandlung erhöht werden.

In Bezug auf FIG. 3 sind Aspekte in Bezug auf eine Abhängigkeit der vorgegebenen Funktion 170 von der Temperatur dargestellt. Insbesondere ist es möglich, dass Analogkomponenten der Schaltung 100 eine signifikante Abhängigkeit des Betriebs von der Temperatur aufweisen. Zum Beispiel könnte der Komparator 111 eine Abhängigkeit von der Temperatur aufweisen. Es wäre alternativ oder zusätzlich auch möglich, dass das DA-Wandlerelement 114 eine Abhängigkeit des Betriebs von der Temperatur aufweist. Insbesondere ist es auch möglich, dass der Detektor 101 eine Abhängigkeit von der Temperatur aufweist.

In FIG. 3 ist ein Szenario dargestellt, in welchem die Schaltung 110 einen Temperatursensor 152 umfasst. Der Temperatursensor 152 misst die Temperatur im Bereich der Schaltung 110. Dann ist der Temperatursensor 152 eingerichtet, um ein Steuersignal bereitzustellen, welches indikativ für die gemessene Temperatur ist. Es ist dann möglich, dass die vorgegebene Funktion 170 eine Abhängigkeit von der gemessenen Temperatur aufweist. Zum Beispiel könnten in einem Szenario, bei dem die vorgegebene Funktion 170 durch die LUT abgebildet wird, die LUT für eine bestimmte Bit-Abfolge des Digitalsignals 184 verschiedene zugeordnete Bit-Abfolgen des übersetzten Digitalsignals 185 aufweisen, wobei die jeweilige Zuordnung basierend auf der gemessenen Temperatur ausgewählt werden kann. Durch das Vorsehen der Abhängigkeit der vorgegebenen Funktion 170 von der Temperatur können Einflüsse der Temperatur auf das Wandeln des Eingangssignals 182 in das Ausgangssignal 187 reduziert bzw. kompensiert werden. Es ist möglich, die nichtlineare Charakteristik besonders temperaturstabil bereit zu stellen.

In Bezug auf FIG. 4 sind Aspekte dargestellt, die eine Abhängigkeit der vorgegebenen Funktion 170 von einem Typ bzw. einem Betriebszustand des Detektors 101 betreffen. Wie aus FIG. 4 ersichtlich, weist in diesem Szenario der Detektor 101 eine Kopplung mit dem Logikelement 113 auf. Dadurch ist es möglich, dass das Logikelement 113 eine Abhängigkeit der vorgegebenen Funktion 170 von dem Typ des Detektors 101 und/oder von einem Betriebszustand des Detektors 101 implementiert. Insbesondere kann, wie oben stehend beschrieben, das Signal 181 auf eine bestimmte Art und Weise im Analogbereich durch den Detektor 101 vorkonditioniert werden, z.B. quadriert werden. Typischerweise kann, je nach Betriebszustand des Detektors 101 bzw. je nach Typ des Detektors 101, die Vorkonditionierung des Signals 181 variieren. Hier kann es erstrebenswert sein, die vorgegebene Funktion 170 entsprechend anzupassen, um Variationen in der Vorkonditionierung des Signals 181 auszugleichen bzw. zu kompensieren. Zum Beispiel könnte in einem Szenario, in dem die vorgegebene Funktion 170 durch die LUT abgebildet wird, die LUT für eine bestimmte Bit-Abfolge des Digitalsignals 184 verschiedene zugeordnete Bit-Abfolgen des übersetzten Digitalsignals 185 aufweisen, wobei die jeweilige Zuordnung basierend auf dem Typ des Detektors 101 bzw. dem Betriebszustand des Detektors 101 ausgewählt werden kann.

In Bezug auf FIG. 5 sind verschiedene Aspekte eines selektiv aktivierbaren Nebenwegs 600, der eingerichtet ist, um das digitale Logikelement 113 zu umgehen, illustriert. Insbesondere umfasst in dem Szenario der FIG. 5 der Rückkopplungszweig 120 den selektiv aktivierbaren Nebenweg 600, der bewirkt, dass das Digitalsignal 184 ggf. ohne übersetzt zu werden an das DA-Wandlerelement 114 weitergereicht werden kann. Derart kann erreicht werden, dass, je nachdem ob der selektiv aktivierbare Nebenweg 600 aktiv oder inaktiv ist, die nichtlineare Charakteristik des SAR-ADC 110, mit der das Eingangssignal 182 in das Ausgangssignal 187 gewandelt wird, angepasst wird. Derart kann es zum Beispiel möglich sein, zwischen einer linear-in-dB Skala und einer linearen Skala, die einer linearen Charakteristik des SAR-ADC 110 entspricht, für das Ausgangssignals 187 umzuschalten. Dies bedeutet, dass es möglich ist, mittels des Nebenwegs 600 die nichtlineare Charakteristik zu umgehen. Dadurch ist es möglich, den SAR-ADC 110 je nach Anwendungsfall mit einer linearen oder nichtlinearen Charakteristik zu betreiben.

In verschiedenen Szenarien ist es möglich, dass der Nebenweg 600 durch entsprechende Hardware implementiert wird. Zum Beispiel könnte der Nebenweg 600 durch einen oder mehrere Schalter und eine dedizierte Leiterbahn implementiert werden. In weiteren Szenarien ist es jedoch auch möglich, dass der Nebenweg 600 durch Software implementiert wird. Zum Beispiel wäre es möglich, dass der Rückkopplungszweig 120 eingerichtet ist, um das Digitalsignal 184 in dem ersten Betriebsmodus gemäß der vorgegebenen Funktion 170 zu übersetzen, und in dem zweiten Betriebsmodus gemäß einer Identitätsfunktion zu übersetzen. Die Identitätsfunktion bewirkt, dass das Digitalsignal 184 unverändert, d.h. identisch, an das DA-Wandlerelement 114 übergeben wird. Das Digitalsignal 184 und das übersetzte Digitalsignal 185 sind dann identisch.

Voranstehend wurden Techniken illustriert, welche es mittels des digitalen Logikelements 113 in dem Rückkopplungszweig 120 des SAR-ADC 110 ermöglichen, die nichtlineare Charakteristik, mit welcher der SAR-ADC 110 das Eingangssignal 182 in das Ausgangssignal 187 wandelt, zu implementieren. Die nichtlineare Charakteristik weist eine Abhängigkeit von der vorgegebenen Funktion 170 auf. Deshalb kann es erstrebenswert sein, die vorgegebene Funktion 170 in Abhängigkeit von der spezifischen Anwendung flexibel zu implementieren. Z.B. kann es erstrebenswert sein, die vorgegebene Funktion 170 als exponentielle Funktion zu wählen, sodass die nichtlineare Charakteristik logarithmisch ausgebildet ist.

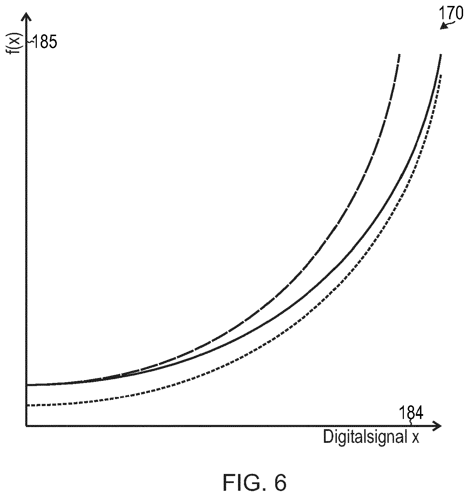

In Bezug auf FIG. 6 sind verschiedene Aspekte betreffend die vorgegebene Funktion 170 dargestellt. Die vorgegebene Funktion 170 wird von dem digitalen Logikelement 113 dazu verwendet, um das Digitalsignal 184 in das übersetzte Digitalsignal 185 zu übersetzen. Zum Beispiel kann die vorgegebene Funktion 170, wie in FIG. 6 dargestellt, eine nichtlineare Funktion sein. Insbesondere wäre es möglich, wie in FIG. 6 dargestellt, dass die vorgegebene Funktion 170 eine exponentielle Funktion ist. Die exponentielle Funktion kann insbesondere durch folgende Abhängigkeit beschrieben sein:

$$f(x)=\exp(x),$$

wobei x den Wert des Digitalsignals 184 bezeichnet.

Die exponentielle Funktion 170 ist typischerweise durch eine bestimmte Steigung charakterisiert; zum Beispiel weist in dem Szenario der FIG. 6 eine erste vorgegebene Funktion 170 (durchgezogene Linie) eine erste Steigung auf und eine zweite und dritte vorgegebene Funktion (gestrichelte Linie und gepunktete Linie) weisen eine zweite Steigung auf, wobei die zweite Steigung größer als die erste Steigung ist. Je nach Anwendung kann derart das Übersetzen des Digitalsignals 184 in das übersetzte Digitalsignal 185 angepasst werden und damit die nichtlineare Charakteristik des SAR-ADC 110 angepasst werden.

Typischerweise ist die exponentielle Funktion 170 weiterhin durch einen bestimmten Nullpunktversatz charakterisiert. In dem Szenario der FIG. 6 weisen die erste und zweite exponentielle Funktion 170 einen ersten Nullpunktversatz auf und die dritte exponentielle Funktion 170 weist einen zweiten Nullpunktversatz auf, wobei der erste Nullpunktversatz größer als der zweite Nullpunktversatz ist. Je nach Anwendung kann derart das Übersetzen des Digitalsignals 184 in das übersetzte Digitalsignal 185 angepasst werden und damit die nichtlineare Charakteristik des SAR-ADC 110 angepasst werden.

Z.B. können Parameter der vorgegebenen Funktion 170 wie die Steigung oder der Nullpunktversatz in Abhängigkeit der durch den Temperatursensor 152 gemessenen Temperatur und / oder in Abhängigkeit von einem Typ des Detektors 101 und / oder in Abhängigkeit von einem Betriebszustand des Detektors 101 angepasst werden.

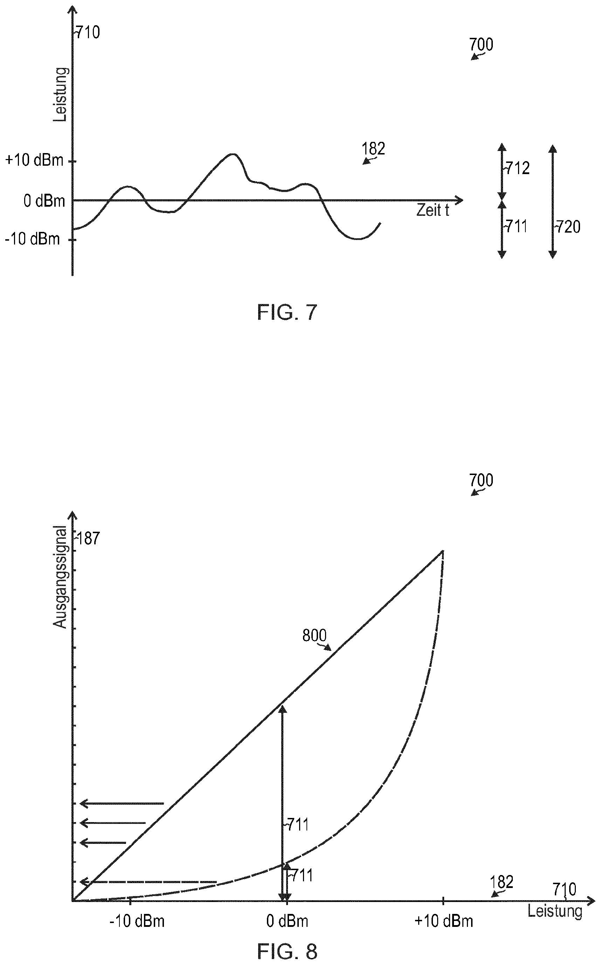

In Bezug auf die FIGs. 7,8 und 9 sind nachfolgend Details betreffend Aspekte der nichtlinearen Charakteristik, mit der das Eingangssignal 182 in das Ausgangssignal 187 gewandelt wird, dargestellt. In FIG. 7 ist die Leistung 710 des Eingangssignals 182 als Funktion der Zeit (Leistungskurve 700) dargestellt. Wie aus FIG. 7 ersichtlich ist, variiert die Leistung 710 des Eingangssignals 182 in einem großen Dynamikbereich 720, der sich über mehrere Größenordnungen erstreckt. Die Leistungskurve 700 umfasst entsprechend einen ersten Bereich 711 und einen zweiten Bereich 712. Dabei entspricht der erste Bereich 711 kleineren Leistungen 710 des Eingangssignals 182, als der zweite Bereich 712.

Mittels der hierin beschriebenen Techniken ist es möglich, eine zuverlässige und genaue AD-Wandlung in dem gesamten Dynamikbereich 720 vorzunehmen. Insbesondere kann es möglich sein durch die nichtlineare Charakteristik des SAR-ADC 110 auch den ersten Bereich 711 mit einer großen Sensitivität AD zu wandeln.

In FIG. 8 ist der Wert des Ausgangssignals 187 als Funktion der Leistung 710 des Eingangssignals 182 dargestellt; dabei illustriert die durchgezogene Linie eine nichtlineare Charakteristik 800 und die gestrichelte Linie illustriert eine lineare Charakteristik 800, mit welcher das Eingangssignal 182 in das Ausgangssignal 187 gewandelt wird (zu beachten ist die logarithmische Skalierung der Leistungs-Achse, in FIG. 8 horizontal dargestellt). Sofern die AD-Wandlung mit der nichtlinearen Charakteristik 800 stattfindet, wird das Ausgangssignal 187 auf einer linear-in-dB Skala bereitgestellt (in FIG. 8 durch die Gerade der durchgezogenen Linie dargestellt).

Aus FIG. 8 ist ersichtlich, dass im Falle der linearen Charakteristik 800 (gestrichelte Linie) dem ersten Bereich 711 nur ein einzelner Digitalwert des diskretisierten Ausgangssignals 187 (in FIG. 8 durch die Ticks auf der vertikalen Achse und den gestrichelten horizontalen Pfeil dargestellt) zugeordnet ist; deshalb erfolgt das AD-Wandeln mit der linearen Charakteristik 800 nicht mit einer erkennbaren Sensitivität.

Aus FIG. 8 ist auch ersichtlich, dass im Falle der nichtlinearen Charakteristik 800 dem ersten Bereich 711 der Leistungskurve 700 des Eingangssignal 182 ein größerer Wertebereich in Bezug auf das diskretisierte Ausgangssignal 187 (in FIG. 8 durch die Ticks auf der vertikalen Achse und die durchgezogenen horizontalen Pfeile dargestellt) zugeordnet wird; deshalb erfolgt das AD-Wandeln mit der linearen Charakteristik nicht mit einer erkennbaren Sensitivität 800.

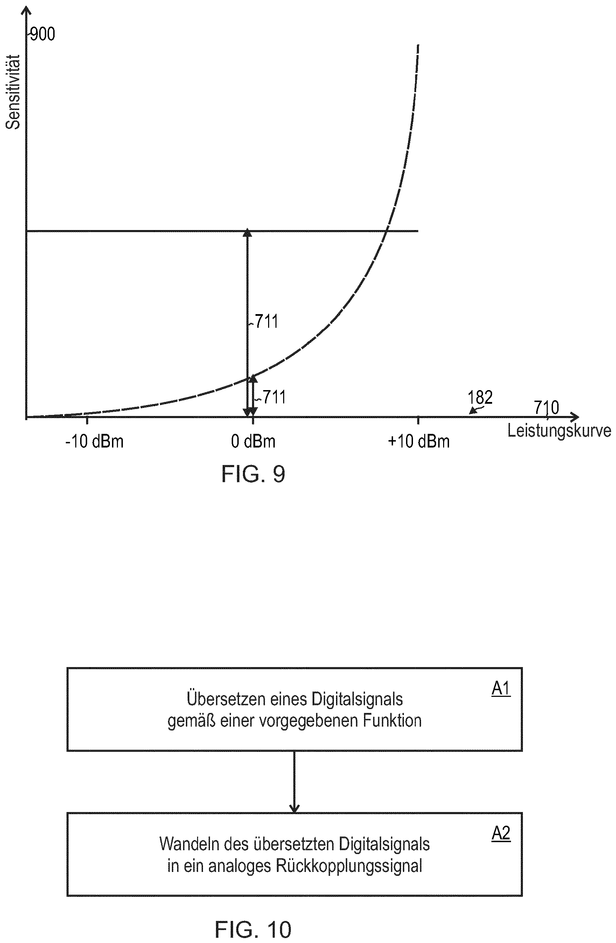

Im Detail entspricht eine Steigung der in FIG. 8 dargestellten Kurven einer Sensitivität, mit der die AD-Wandlung durchgeführt wird; dabei entspricht eine geringere (größere) Steigung einer geringeren (größeren) Sensitivität. In FIG. 9 ist die Sensitivitäten 900 für die nichtlineare Charakteristik 800 (durchgezogene Linie) und die lineare Charakteristik 800 (gestrichelte Linie) dargestellt. Aus FIG. 9 ist ersichtlich, dass der erste Bereich 711 des Eingangssignals und der zweite Bereich 712 des Eingangssignals 182 im Falle der nichtlinearen Charakteristik 800 mit im Wesentlichen gleichen Sensitivitäten gewandelt werden. Insbesondere erfolgt das AD-Wandeln mit einer konstanten Sensitivität 900 über den gesamten Dynamikbereich 720. Insbesondere ist eine Sensitivität 900 mit der der erste Bereich 711 des Eingangssignals 182 gewandelt wird vergleichsweise groß und erkennbar. Die erkennbare Sensitivität 900 kann bedeuten, dass das Ausgangssignal 187 in Bezug auf den ersten Bereich 711 eine ausreichende Anzahl von Datenpunkten aufweist. Derart kann eine hohe Auflösung der AD-Wandlung auch in dem ersten Bereich 711, der kleineren Leistungen entspricht, erreicht werden.

In FIG. 10 ist ein Flussdiagramm eines Verfahrens gemäß verschiedener Ausführungsformen dargestellt. Das Verfahren umfasst das Übersetzen des Digitalsignals 184 gemäß der vorgegebenen Funktion 170 in dem Rückkopplungszweig 120 des SAR-ADC 110, A1. Dabei kann die vorgegebene Funktion 170 zum Beispiel eine nichtlineare Funktion sein, zum Beispiel insbesondere eine exponentielle Funktion. Das Übersetzen des Digitalsignals 184 in das übersetzte Digitalsignal 185 kann zum Beispiel durch das Logikelement 113 durchgeführt werden. Dabei kann das Logikelement 113 zum Beispiel mit dem Speicher 151 gekoppelt sein, der die LUT speichert. Dann kann es möglich sein, dass das Logikelement 113 unter Verwendung der LUT das Übersetzen des Digitalsignals 184 in das übersetzte Digitalsignal 185 implementiert.

In verschiedenen Ausführungsformen ist es möglich, dass Schritt A1 selektiv ausgeführt wird; zum Beispiel kann mittels des Nebenwegs 600 das Übersetzen des Digitalsignals 184 in das übersetzte Digitalsignal 185 umgangen werden.

Das Verfahren umfasst weiterhin das Wandeln des übersetzten Digitalsignals 185 in das analoge Rückkopplungssignal 186 in dem Rückkopplungszweig 120 des SAR-ADC 110, A2. Zum Beispiel kann A2 durch das DA-Wandlerelement 114 durchgeführt werden.

Das Verfahren kann z.B. weiterhin das Vergleichen des Rückkopplungssignals 186 mit dem Eingangssignal und das Ausgeben des Ergebnissignals 183 basierend auf dem Vergleichen umfassen (in FIG. 10 nicht dargestellt).

Das Verfahren kann weiterhin das iterative Anpassen des Digitalsignals 184 basierend auf dem Ergebnissignal 183 umfassen (in FIG. 10 nicht dargestellt).

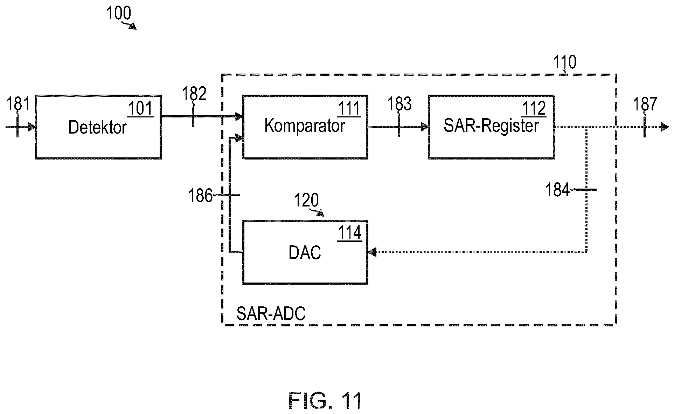

In FIG. 11 ist ein vorbekannter SAR-ADC 110 gemäß Referenz-Implementierungen dargestellt, vgl. Tietze, Schenk, Gamm, Halbleiterschaltungstechnik", 14. Auflage (2012), Kapitel 17.2.2 "Wägeverfahren mit geschalteten Spannungen". Bei dem vorbekannten SAR-ADC 110 wird das Digitalsignal 184 ohne Übersetzung an das Digital-Analog-Wandlerelement 114 übergeben. Es ist kein Logikelement 113, welches eingerichtet ist, um das Digitalsignal 184 zu übersetzen, vorhanden.

Zusammenfassend wurden voranstehend Techniken erläutert, die basierend auf dem Wägeverfahren eine AD-Wandlung implementieren. Der entsprechende SAR-ADC umfasst Rückkopplungszweig mit einer vorgegebenen Funktion. Zum Beispiel kann die vorgegebene Funktion eine exponentielle Abhängigkeit aufweisen. In Kombination mit einem herkömmlichen linearen DA-Wandlerelement kann dann eine logarithmische Charakteristik der AD-Wandlung implementiert werden.

Derart können verschiedene Vorteile erhalten werden. Ein besonderer Vorteil liegt in der starken Reduktion von analoger Schaltungstechnik, die typischerweise besonders sensitiv auf Schwankungen der Temperatur, Offset-Spannungen und Prozessvariationen reagiert. Insbesondere kann das Übersetzen basierend auf der vorgegebenen Funktion im Digitalbereich stattfinden.

Solche Techniken können in verschiedensten Gebieten Anwendung finden. Ein spezieller Anwendungsbereich ist die Bestimmung eines RMS-Werts eines Eingangssignals, wie zum Beispiel einem Hochfrequenz-Signal.

Voranstehend wurden verschiedenste Aspekte in Bezug auf die Leistung des Eingangssignals, die mit einer nichtlinearen Charakteristik AD gewandelt wird, beschrieben. In weiteren Szenerien wäre es möglich, dass das Eingangssignal eine Kurve einer anderen Kenngröße aufweist, die mittels der nichtlinearen Charakteristik AD gewandelt wird. Beispiele für weitere Kenngrößen umfassen z.B. Spannung, Feldstärke, Licht, Temperatur, Magnetfeld.

## Patentansprüche

1. Schaltung (100), die umfasst:

   - einen Sukzessiv-Approximativen Analog-Digital-Wandler, SAR-ADC (110), wobei der SAR-ADC (110) ein SAR-Register (112) und einen Rückkopplungszweig (120) umfasst,

   wobei der SAR-ADC (110) eingerichtet ist, um ein von dem SAR-ADC (110) empfangenes analoges Eingangssignal (182) mittels einer nichtlinearen Charakteristik (800) in ein digitales Ausgangssignal (187) zu wandeln,
   wobei der Rückkopplungszweig (120) eingerichtet ist, um ein vom SAR-Register (112) ausgegebenes Digitalsignal (184) gemäß einer vorgegebenen Funktion (170) zu übersetzen und um weiterhin das übersetzte Digitalsignal (185) in ein analoges Rückkopplungssignal (186) zu wandeln,
   wobei der Rückkopplungszweig (120) ein digitales Logikelement (113) und ein Digital-Analog-Wandlerelement (114) umfasst,
   wobei das digitale Logikelement (113) eingerichtet ist, um das Digitalsignal (184) gemäß der vorgegebenen Funktion (170) zu übersetzen,
   wobei das Digital-Analog-Wandlerelement (114) eingerichtet ist, um das übersetzte Digitalsignal (184) in das analoge Rückkopplungssignal (186) zu wandeln,
   wobei die Schaltung weiterhin umfasst:

   - einen Temperatursensor (152), der eingerichtet ist, um ein Signal an das digitale Logikelement (113) auszugeben, wobei das Signal indikativ für eine im Bereich der Schaltung (110) gemessene Temperatur ist,

wobei die vorgegebene Funktion (170) eine Abhängigkeit von der gemessenen Temperatur aufweist, so dass Einflüsse der Temperatur auf ein Wandeln des Eingangssignals (182) in das Ausgangssignal (187) reduziert oder kompensiert werden und die nichtlineare Charakteristik (800) temperaturstabil bereitgestellt wird.

2. Schaltung (100) nach Anspruch 1, die weiterhin umfasst:

- einen Speicher (151), der eingerichtet ist, um eine Nachschlagetabelle zu speichern, welche die vorgegebene Funktion (170) abbildet,

wobei das Logikelement (113) eingerichtet ist, um das Digitalsignal (184) gemäß der vorgegebenen Funktion (170) basierend auf der Nachschlagetabelle zu übersetzen.

3. Schaltung (100) nach Anspruch 1 oder 2, wobei der Rückkopplungszweig (120) weiterhin einen selektiv aktivierbaren Nebenweg (600) umfasst, der eingerichtet ist, um das digitale Logikelement (113) zu umgehen.

4. Schaltung (100) nach einem der voranstehenden Ansprüche, wobei die vorgegebene Funktion (170) eine nichtlineare Funktion ist.

5. Schaltung (100) nach Anspruch 4 wobei die vorgegebene Funktion (170) eine exponentielle Funktion ist.

6. Schaltung (100) nach einem der voranstehenden Ansprüche, wobei die vorgegebene Funktion (170) einen Nullpunktversatz aufweist.

7. Schaltung (100) nach einem der voranstehenden Ansprüche, wobei der Rückkopplungszweig (120) eingerichtet ist, um das Digitalsignal (184) in einem ersten Betriebsmodus gemäß der vorgegebenen Funktion (170) zu übersetzen und in einem zweiten Betriebsmodus gemäß einer weiteren vorgegebenen Funktion (170) zu übersetzen.

8. Schaltung (100) nach Anspruch 7, wobei die weitere vorgegebene Funktion (170) die Identitätsfunktion ist.

9. Schaltung (100) nach einem der voranstehenden Ansprüche, die weiterhin umfasst:

- einen Detektor (101), der eingerichtet ist, um ein analoges Eingangssignal (182) an den SAR-ADC (110) auszugeben.

10. Schaltung (100) nach Anspruch 9, wobei die vorgegebene Funktion (170) eine Abhängigkeit von einem Typ des Detektors (101) und/oder von einem Betriebszustand des Detektors (101) aufweist.

11. Verfahren, das umfasst:

- Messen einer Temperatur im Bereich einer Schaltung (110), die einen Sukzessiv-Approximativen Analog-Digital-Wandler, SAR-ADC (110) umfasst, bestehend aus einem SAR-Register (112) und einem Rückkopplungszweig (120);
- Ausgeben eines Signals, welches für die gemessene Temperatur indikativ ist,
- Wandeln eines analoges Eingangssignals (182) mittels des SAR-ADC (110) und einer nichtlinearen Charakteristik (800) in ein digitales Ausgangssignal (187),

wobei das Wandeln umfasst:

- der Rückkopplungszweig (120) des SAR-ADC (110) übersetzt ein vom SAR-Register (112) ausgegebenes Digitalsignal (184) gemäß einer vorgegebenen Funktion (170), die eine Abhängigkeit von der gemessenen Temperatur aufweist, so dass Einflüsse der Temperatur auf das Wandeln des Eingangssignals (182) in das Ausgangssignal (187) reduziert oder kompensiert werden und die nichtlineare Charakteristik (800) temperaturstabil bereitgestellt wird, und
- der Rückkopplungszweig (120) des SAR-ADC (110) wandelt das übersetzte Digitalsignal (185) in ein analoges Rückkopplungssignal (186).

**Claims**

1. Circuit (100) that comprises:

- a successive approximation analogue-to-digital converter, SAR-ADC (110), wherein the SAR-ADC (110) comprises an SAR register (112) and a feedback path (120),

wherein the SAR-ADC (110) is set up to convert an analogue input signal (182) received by the SAR-ADC (110) into a digital output signal (187) by means of a non-linear characteristic (800), wherein the feedback path (120) is set up to translate a digital signal (184) output by the SAR register (112) in accordance with a prescribed function (170) and to furthermore convert the translated digital signal (185) into an analogue feedback signal (186),

wherein the feedback path (120) comprises a digital logic element (113) and a digital-to-analogue converter element (114),

wherein the digital logic element (113) is set up to translate the digital signal (184) in accordance with the prescribed function (170),

wherein the digital-to-analogue converter element (114) is set up to convert the translated digital signal (184) into the analogue feedback signal (186),

wherein the circuit furthermore comprises:

- a temperature sensor (152) that is set up to output a signal to the digital logic element (113), wherein the signal is indicative of a temperature measured in the region of the circuit (110),

wherein the prescribed function (170) has a dependency on the measured temperature, with the result that influences of the temperature on conversion of the input signal (182) into the output signal (187) are reduced or compensated for, and the non-linear characteristic (800) is provided in a temperature-stable manner.

2. Circuit (100) according to Claim 1, furthermore comprising:

- a memory (151) that is set up to store a lookup table that maps the prescribed function (170),

wherein the logic element (113) is set up to translate the digital signal (184) in accordance with the prescribed function (170) on the basis of the lookup table.

3. Circuit (100) according to Claim 1 or 2, wherein the feedback path (120) furthermore comprises a selectively activable shunt path (600) that is set up to bypass the digital logic element (113).

4. Circuit (100) according to one of the preceding claims, wherein the prescribed function (170) is a non-linear function.

5. Circuit (100) according to Claim 4, wherein the prescribed function (170) is an exponential function.

6. Circuit (100) according to one of the preceding claims, wherein the prescribed function (170) has a zero point offset.

7. Circuit (100) according to one of the preceding claims, wherein the feedback path (120) is set up to translate the digital signal (184) in accordance with the prescribed function (170) in a first mode of operation and to translate said digital signal in accordance with a further prescribed function (170) in a second mode of operation.

8. Circuit (100) according to Claim 7, wherein the further prescribed function (170) is the identity function.

9. Circuit (100) according to one of the preceding claims, furthermore comprising:

- a detector (101) that is set up to output an analogue input signal (182) to the SAR-ADC (110).

10. Circuit (100) according to Claim 9, wherein the prescribed function (170) has a dependency on a type of the detector (101) and/or on an operating state of the detector (101).

11. Method that comprises:

- measuring a temperature in the region of a circuit (110) that comprises a successive approximation analogue-to-digital converter, SAR-ADC (110), comprising an SAR register (112) and a feedback path (120);
- outputting a signal that is indicative of the measured temperature;
- converting an analogue input signal (182) into a digital output signal (187) by means of the SAR-ADC (110) and a non-linear characteristic (800),

wherein the conversion comprises:

- the feedback path (120) of the SAR-ADC (110) translates a digital signal (184) output by the SAR register (112) in accordance with a prescribed function (170) that has a dependency on the measured temperature, with the result that influences of the temperature on the conversion of the input signal (182) into the output signal (187) are reduced or compensated for, and the non-linear characteristic (800) is provided in a temperature-stable manner, and
- the feedback path (120) of the SAR-ADC (110) converts the translated digital signal (185) into an analogue feedback signal (186).

**Revendications**

1. Circuit (100), comprenant :

- un convertisseur analogique/numérique à approximations successives, SAR-ADC (110), le SAR-ADC (110) comprenant un registre SAR (112) et une branche de rétroaction (120),

le SAR-ADC (110) étant aménagé pour convertir un signal d'entrée analogique (182), reçu par le SAR-ADC (110), en un signal de sortie numérique (187) au moyen d'une caractéristique non linéaire (800), la branche de rétroaction (120) étant aménagée pour traduire un signal numérique (184), sorti par le registre SAR (112), selon une fonction prédéfinie (170) et pour convertir en outre le signal numérique (185) traduit en un signal de rétroaction analogique (186), la branche de rétroaction (120) comprenant un élément logique numérique (113) et un élément de conversion numérique/analogique (114),
l'élément logique numérique (113) étant aménagé pour traduire le signal numérique (184) selon la fonction prédéfinie (170),
l'élément de conversion numérique/analogique (114) étant aménagé pour convertir le signal numérique (184) traduit en signal de rétroaction analogique (186),
le circuit comprenant en outre :

- un capteur de température (152) qui est aménagé pour sortir un signal à destination de l'élément logique numérique (113), le signal indiquant une température mesurée au niveau du circuit (110),

la fonction prédéfinie (170) présentant une dépendance de la température mesurée de sorte que des influences de la température sur une conversion du signal d'entrée (182) en signal de sortie (187) sont réduites ou compensées et la caractéristique non linéaire (800) est fournie à température stable.

2. Circuit (100) selon la revendication 1, comprenant en outre :

- une mémoire (151) qui est aménagée pour mémoriser une table de consultation qui reproduit la fonction prédéfinie (170),

l'élément logique (113) étant aménagé pour traduire le signal numérique (184) selon la fonction prédéfinie (170) sur la base de la table de consultation.

3. Circuit (100) selon la revendication 1 ou 2, dans lequel la branche de rétroaction (120) comprend en outre un chemin secondaire (600) pouvant être activé sélectivement et qui est aménagé pour contourner l'élément logique numérique (113).

4. Circuit (100) selon l'une quelconque des revendications précédentes, dans lequel la fonction prédéfinie (170) est une fonction non linéaire.

5. Circuit (100) selon la revendication 4, dans lequel la fonction prédéfinie (170) est une fonction exponentielle.

6. Circuit (100) selon l'une quelconque des revendications précédentes, dans lequel la fonction prédéfinie (170) présente un décalage du zéro.

7. Circuit (100) selon l'une quelconque des revendications précédentes, dans lequel la branche de rétroaction (120) est aménagée pour traduire le signal numérique (184) dans un premier mode de fonctionnement selon la fonction prédéfinie (170) et pour le traduire selon une autre fonction prédéfinie (170) dans un deuxième mode de fonctionnement.

8. Circuit (100) selon la revendication 7, dans lequel l'autre fonction prédéfinie (170) est la fonction d'identité.

9. Circuit (100) selon l'une quelconque des revendications précédentes, comprenant en outre :

- un détecteur (101) qui est aménagé pour sortir un signal d'entrée analogique (182) à destination du SAR-ADC (110).

10. Circuit (100) selon la revendication 9, dans lequel la fonction prédéfinie (170) présente une dépendance d'un type du détecteur (101) et/ou d'un état de fonctionnement du détecteur (101).

11. Procédé, comprenant les étapes consistant à :

- mesurer une température au niveau d'un circuit (110) qui comprend un convertisseur analogique/ numérique à approximations successives, SAR-ADC (110), composé d'un registre SAR (112) et d'une branche de rétroaction (120) ;
- sortir un signal qui indique la température mesurée,
- convertir un signal d'entrée analogique (182) au moyen du SAR-ADC (110) et d'une caractéristique non linéaire (800) en un signal de sortie numérique (187), la conversion comprenant le fait que :
- la branche de rétroaction (120) du SAR-ADC (110) traduise un signal numérique (184) sorti par le registre SAR (112) selon une fonction prédéfinie (170) qui présente une dépendance de la température mesurée de sorte que des influences de la température sur la conversion du signal d'entrée (182) en signal de sortie (187) sont réduites ou compensées, et que la caractéristique non linéaire (800) soit fournie à température stable, et
- la branche de rétroaction (120) du SAR-ADC (110) convertisse le signal numérique traduit (185) en un signal de rétroaction analogique (186).

FIG. 1

FIG. 2

100

181 | Detektor 101 | 182 |

110

Komparator 111 | 183 | SAR-Register 112 | 187

186

120

DAC 114 | 185 | f(x) 113 | 184

170

SAR-ADC

LUT 151 | Temp 152

FIG. 3

100

181 | Detektor 101 | 182 |

110

Komparator 111 | 183 | SAR-Register 112 | 187

186

120

DAC 114 | 185 | f(x) 113 | 184

170

SAR-ADC

LUT 151

FIG. 4

100

110

181

182

183

187

| | | |
|---|---|---|
| Detektor 101 | Komparator 111 | SAR-Register 112 |

184

186

120

600

| | | |
|---|---|---|
| DAC 114 | 185 | f(x) 113 |

170

SAR-ADC

FIG. 5

FIG. 6

FIG. 7

FIG. 8

FIG. 9

FIG. 10

100

110

181 | Detektor 101 | 182 | Komparator 111 | 183 | SAR-Register 112 | 187

186

120

DAC 114

184

SAR-ADC

FIG. 11

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 5920274 A

- JP S5544256 B

**In der Beschreibung aufgeführte Nicht-Patentliteratur**

- Wägeverfahren mit geschalteten Spannungen. **TIETZE ; SCHENK ; GAMM.** Halbleiterschaltungstechnik. 2012